# EUROPÄISCHE PATENTSCHRIFT

(11) **EP 1 024 985 B1**
(45) Veröffentlichungstag und Bekanntmachung des Hinweises auf die Patenterteilung: **15.01.2003**
(21) Anmeldenummer: 98955515.6
(22) Anmeldetag: 22.10.1998
(51) Int. Cl.: B60T 8/88, G01R 31/00, G01R 19/165

(54) **SCHALTUNGSANORDNUNG ZUR SPANNUNGSÜBERWACHUNG EINER GEREGELTEN AUSGANGSSPANNUNG IN EINEM KRAFTFAHRZEUG**
CIRCUIT CONFIGURATION TO MONITOR A REGULATED OUTPUT VOLTAGE IN A MOTOR VEHICLE
CIRCUIT POUR CONTROLER UNE TENSION DE SORTIE REGULEE DANS UN VEHICULE AUTOMOBILE

(30) Priorität: 24.10.1997 DE 19747014; 20.11.1997 DE 19751429
(43) Veröffentlichungstag der Anmeldung: 09.08.2000
(73) Patentinhaber: Continental Teves AG & Co. oHG, 60488 Frankfurt (DE)
(72) Erfinder: ENGELMANN, Mario, D-61449 Steinbach (DE); HEINZ, Micha, D-64293 Darmstadt (DE); FEY, Wolfgang, D-65527 Niedernhausen (DE); ZYDECK, Michael, D-60529 Frankfurt/Main (DE)
(86) Internationale Anmeldenummer: EP9806726
(87) Internationale Veröffentlichungsnummer: WO99021745

(56) Entgegenhaltungen:
- DE-A- 4 436 372
- US-A- 4 707 758
- US-A- 5 648 759
- PATENT ABSTRACTS OF JAPAN vol. 097, no. 008, 29. August 1997 & JP 09 091034 A (MAZDA MOTOR CORP), 4. April 1997

## Beschreibung

Die Erfindung betrifft eine Schaltungsanordnung zur Spannungsüberwachung einer geregelten Ausgangsspannung in einem Kraftfahrzeug nach Patentanspruch 1.

Elektrische und elektronische Bauteile, die in einem Kraftfahrzeug mittels einer elektrischen Spannung betrieben bzw. unter gewissen Umständen angesteuert werden, können zerstört werden, wenn sie mit einer zu geringen oder einer zu großen Spannung beaufschlagt werden. Um Spannungsschwankungen im Bordnetz eines Kraftfahrzeuges auszugleichen, ist es daher bekannt, eine geregelte Ausgangsspannung zur Verfügung zu stellen, deren Ausgangsspannungspegel mittels eines Komparators überwacht wird. Bei dieser geregelten Ausgangsspannung wird die Bordnetzspannung mittels einer Referenzspannung auf einen bestimmten Wert geregelt.

Soll der Schaltungsteil zur Erzeugung der geregelten Ausgangsspannung mit anderen Schaltungsteilen zusammen auf einem Chip integriert werden, so stellt sich weiterhin das Problem, daß der Chip selbst durch eine fehlerhafte Ausgangsspannung zerstört werden kann.

Dies ist insbesondere bei Systemen kritisch, die für die Fahrsicherheit Bedeutung haben, weil im Fehlerfalle ein geordnetes Abschalten des Systems gesichert sein muß, um einen definierten Notlaufzustand aktivieren zu können. Dies gilt beispielsweise für ABS/ASR-Systeme.

In der US 5 648 759 A ist eine Schaltungsanordnung zur Spannungsüberwachung beschrieben, bei der zwei Referenzspannungen eingesetzt werden. Die erste Referenzspannung dient zur Regelung der Ausgangsspannung. Mit Hilfe einer zweiten Referenzspannung bzw. eines Spannuhgsbereichs zwischen einem oberen Grenzwert und einem unteren Grenszwert wird die Ausgangsspannung überwacht. Beide Referenzspannungen werden einer einzigen elektronischen Referenzspannungsquelle entnommen.

Aufgabe der vorliegenden Erfindung ist es, die Ausfallsicherheit derartiger Systeme zu erhöhen.

Diese Aufgabe wird erfindungsgemäß mit einer Schaltungsanordnung zur Regelung und zur Spannungsüberwachung einer geregelten Ausgangsspannung in einem Kraftfahrzeug nach Anspruch 1 gelöst, wobei die geregelte Ausgangsspannung auf das Überschreiten und/oder Unterschreiten bestimmter Schwellwerte überwacht wird, wobei der Schaltungsteil zur Regelung der Ausgangsspannung zusammen mit dem Schaltungsteil zur Überwachung des Über- bzw. Unterschreitens der Schwellwerte auf einem Chip integriert wird und wobei weiterhin-die Regelung der Ausgangsspannung mittels einer ersten Referenzspannung erfolgt und wobei das Überwachen des Über- bzw.

Unterschreitens der Schwellwerte mittels einer zweiten Referenzspannung erfolgt, und welche Schaltungsanordnung dadurch gekennzeichnet ist, daß der Chip zwei räumlich, mechanisch und elektrisch unabhängige Spannungsreferenzen für die erste und die zweite Referenzspannung aufweist.

Dadurch wird vorteilhaft die Sicherheit verbessert, mit der ein Fehler erkannt werden kann. Wenn eine der beiden Referenzspannungen falsche Werte annimmt, kann dies erkannt werden. Wenn die erste Referenzspannung fehlerhaft ist, stellt sich - entsprechend der fehlerhaften ersten Referenzspannung - eine falsche geregelte Ausgangsspannung ein, was mittels der zweiten Referenzspannung erkannt werden kann. Es kann dann also eine Fehlerbehandlung durchgeführt werden bei einer erkannten Abweichung der geregelten Ausgangsspannung von der zweiten Referenzspannung. Wenn die zweite Referenzspannung fehlerhaft ist, nimmt zwar die geregelte Ausgangsspannung noch die richtigen Werte an, es stellt sich aber trotzdem eine Abweichung der geregelten Ausgangsspannung zu der zweiten Referenzspannnung ein, weswegen auch in diesem Falle eine Fehlerbehandlung durchgeführt wird.

Dies erweist sich als vorteilhaft gegenüber einer Schaltungsanordnung, bei der die geregelte Ausgangsspannung mit derselben Referenzspannung erzeugt wird, mit der in einem Komparator die geregelte Ausgangsspannung auf den richtigen Wert überprüft wird. Driftet hierbei die Referenzspannung weg, so ändern sich die Schwellen des Komparators im gleichen Sinne wie die geregelte Ausgangsspannung, so daß der Fehler nicht bemerkt wird. In dem beschriebenen hier vorliegenden Anwendungsfall kann dies aus den angeführten Gründen besonders kritisch sein. Es wird also die Ausfallsicherheit erhöht, weil ein Fehlerfall erkannt werden kann, bevor es zu einer Zerstörung von Bauteilen, insbesondere sicherheitskritischen Bauteilen, kommend kann.

Dies ist besonders vorteilhaft, wenn auch die Treiberstufen für die Verbraucher wie beispielsweise die Ventiltreiber bei einem ABS/ASR-System mit auf dem Chip integriert sind.

Bei der Ausgestaltung der Schaltungsanordnung nach Anspruch 2 wird auch die erste Referenzspannung verwendet, um die geregelte Ausgangsspannung zu überprüfen.

Damit kann beispielsweise festgestellt werden, ob die Spannungsregelung bei einer korrekt vorgegebenen ersten Referenzspannung fehlerhaft arbeitet. Durch diese Maßnahme wird also die Erkennung von potentiellen Fehlern weiter verbessert und damit weiterhin die Ausfallsicherheit des Systems erhöht.

Bei der Ausgestaltung der Schaltungsanordnung nach Anspruch 3 wird mittels der Ausgangsspannung eine weitere elektronische Schaltung versorgt, wobei diese Schaltung mittels eines auf dem Chip der Schaltungsanordnung integrierten Watchdog-Schaltungsteiles überwacht wird, wobei der Oszillator des Watchdog-Schaltungsteiles mittels der zweiten Referenzspannung versorgt wird.

Durch diese Ausgestaltung kann insbesondere sichergestellt werden, daß die Kontrolle der weiteren elektronischen Schaltung in der Schaltungsanordnung unter Verwendung der zweiten Referenzspannung erfolgt. Wenn also aufgrund einer fehlerhaften ersten Referenzspannung an die weitere elektronische Schaltung eine fehlerhafte Spannung geliefert wird, kann dies aufgrund der von der weiteren elektronischen Schaltung an die Watchdog-Schaltung gelieferten Signale erkannt werden. Ebenso kann von der Watchdog-Schaltung natürlich erkannt werden, wenn keine Signale mehr geliefert werden.

Bei der Ausgestaltung der Schaltungsanordnung nach Anspruch 4 werden bei einem durch den Watchdog-Schaltungsteil erkannten Fehler Treiberstufen für externe Verbraucher abgeschaltet.

Dies erweist sich dann als besonders vorteilhaft, wenn diese Treiberstufen auf dem Chip integriert sind. Es wird dann durch diese Maßnahme eine Zerstörung des Chip sicher vermieden. Außerdem kann das System in einen Notlaufzustand umgeschaltet werden.

Bei der Schaltungsanordnung nach Anspruch 6 wird bei einem durch den Watchdog-Schaltungsteil erkannten Fehler eine Treiberstufe zur Einschaltung von Warnlampen aktiviert.

Dadurch ist ein Fehler und eine dadurch bedingte Abschaltung des Systems leicht erkennbar.

Bei der Schaltungsanordnung nach Anspruch 7 ist die weitere elektronische Schaltung ein Mikroprozessor. Weiterhin erfolgt die Überprüfung der Ausgangsspannung mittels der ersten Referenzspannung durch einen auf dem Chip der Schaltungsanordnung integrierten Komparator, wobei ein Reset des Mikroprozessors erfolgt, wenn von dem Komparator das Über- bzw. Unterschreiten eines bestimmten Schwellwertes erkannt wurde.

Es wird dadurch in einfacher Weise möglich, ohne größeren schaltungstechnischen Aufwand eine Überprüfung mit der ersten Referenzspannung vorzunehmen. Wenn diese erste Referenzspannung als Vergleichsspannung zur geregelten Ausgangsspannung an den Eingang des Komparators gelegt wird und der Ausgang des Komparators auf einen Reset-Eingang des Mikroprozessors gelegt wird, erfolgt ein Reset des Mikroprozessors, wenn von dem Komparator eine unzulässige Abweichung der geregelten Ausgangsspannung von der ersten Referenzspannung festgestellt wird. Über den Reset-Eingang des Mikroprozessors erfolgt ein Reset der Mikroprozessors. Durch diesen Reset des Mikroprozessors werden dem Watchdog-Schaltungsteil keine Signale mehr zugeführt, so daß von dem Watchdog-Schaltungsteil der Schaltungsanordnung ein Fehlerfall erkannt wird. Mittels dieses (von der zweiten Referenzspannung versorgten) Watchdog-Schaltungsteiles werden die weiteren entsprechenden Maßnahmen eingeleitet wie beispielsweise die Abschaltung der Treiberstufen von Verbrauchern und die Aktivierung eines Treibers zur Ansteuerung von Warnlampen.

Mit geringem schaltungstechnischem Aufwand kann also eine Erkennung einer Fehlersituation mit einer Deaktivierung des Systems (Reset des Mikroprozessors, Deaktivierung von Verbrauchern) erfolgen.

Bei der Schaltungsanordnung nach Anspruch 8 wird die Ausgangsspannung der Reglers einem Eingang eines Komparators zugeführt, dessen anderem Eingang die zweite Referenzspannung zugeführt wird, wobei mittels des Komparators überwacht wird, ob ein bestimmter Schwellwert der Ausgangsspannung über- bzw. unterschritten wurde.

Dadurch wird unmittelbar der Pegel der Ausgangsspannung mit der zweiten Referenzspannung verglichen.

Bei der Schaltungsanordnung nach Anspruch 9 werden bei einem durch den Komparator erkannten Über- bzw. Unterschreiten des bestimmten Schwellwertes Treiberstufen für externe Verbraucher abgeschaltet.

Dies erweist sich dann als besonders vorteilhaft, wenn diese Treiberstufen auf dem Chip integriert sind. Es wird dann durch diese Maßnahme eine Zerstörung des Chip sicher vermieden. Außerdem kann das System in einen Notlaufzustand umgeschaltet werden.

Bei der Schaltungsanordnung nach Anspruch 10 wird bein einem durch den Komparator erkannten Über- bzw. Unterschreiten des bestimmten Schwellwertes eine Treiberstufe zur Einschaltung von Warnlampen aktiviert.

Dadurch ist ein Fehler und eine dadurch bedingte Abschaltung des Systems leicht erkennbar.

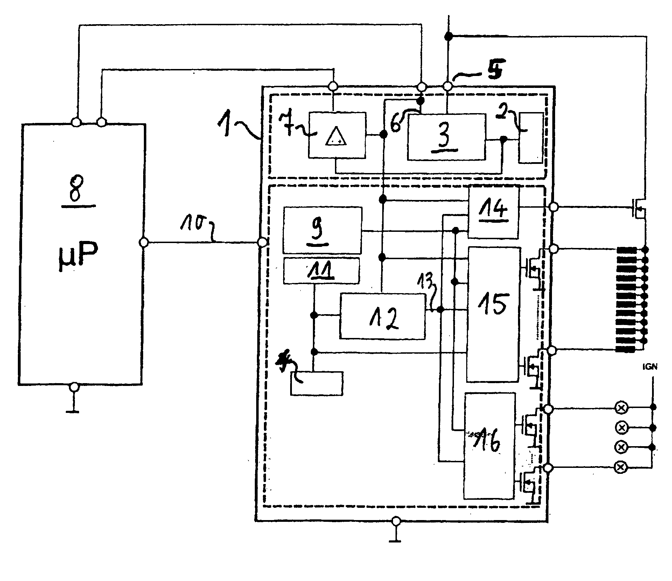

Ein Ausführungsbeispiel der Erfindung ist in der Zeichnung näher dargestellt. Die einzige Figur zeigt eine Schaltungsanordnung 1 zur Spannungsüberwachung einer geregelten Ausgangsspannung in einem Kraftfahrzeug, wobei die gezeigte Schaltungsanordnung 1 in einem ABS/ASR-System Verwendung findet.

In der Schaltungsanordnung stehen zwei voneinander unabhängige Referenzspannungen 2 und 4 zur Verfügung. Ein Schaltungsteil 3 der Schaltungsanordnung 1 besteht aus einem Spannungsregler, dem über den Anschluß 5 der Schaltungsanordnung 1 die Bordnetzspannung des Kraftfahrzeuges zugeführt wird sowie weiterhin die erste Referenzspannung entsprechend dem Block 2 in der Prinzipdarstellung der Figur. Von dem Schaltungsteil 3 wird die geregelte Ausgangsspannung an dem Anschluß 6 ausgegeben, die sowohl intern in der Schaltungsanordnung 1 als auch zur Spannungsversorgung externer Geräte zur Verfügung steht.

Einem Komparator 7 wird die erste Referenzspannung entsprechend dem Block 2 sowie die geregelte Ausgangsspannung von dem Ausgang 6 des Schaltungsteiles 3 zugeführt. Erkennt der Komparator 7 eine zu große Differenz zwischen seinen beiden Eingangsspannungen, erfolgt über den Ausgang des Komparators 7 ein Reset eines Mikroprozessors 8, indem ein entsprechendes Ausgangssignal des Komparators 7 einem Eingang des Mikroprozessors 8 zugeführt wird. Dieser Mikroprozessor 8 stellt eine weitere elektronische Schaltung dar, die von der Schaltungsanordnung überwacht wird. Dazu weist die Schaltungsanordnung 1 ein Watchdog-Schaltungsteil 9 auf. Von dem Mikroprozessor 8 werden entsprechend der Darstellung der Verbindung 10 Signale an die Schaltungsanordnung 1 ausgegeben, mittels denen ein möglicher Fehler des Mikroprozessors 8 erkannt werden soll. Wenn also ein Reset des Mikroprozessors 8 erfolgt, werden keine Signale mehr über die Verbindung 10 ausgegeben, was von dem Watchdog-Schaltungsteil 9 als Fehler erkannt wird.

Der Oszillator 11 des Watchdog-Schaltungsteiles 9 wird mit der zweiten Referenzspannung 4 beaufschlagt, um die Oszillationsfrequenz des Watchdog-Schaltungsteiles 9 zu generieren. Weiterhin wird einem weiteren Komparator 12 sowohl die geregelte Ausgangsspannung über den Ausgang 6 des Schaltungsteiles 3 als auch die zweite Referenzspannung entsprechend dem Block 4 zugeführt. Wird von dem Komparator 12 eine zu große Abweichung zwischen den beiden Eingangsspannungen festgestellt, wird über den Ausgang 13 des Komparators 12 ein entsprechendes Signal ausgegeben, mit dem der Haupttreiber (Main Treiber) 14 sowie die Ventiltreiberausgänge 15 der Ventile in der Bremsanlage des mit einem ABS/ASR ausgestatteten Kraftfahrzeuges abgeschaltet werden. Weiterhin ist noch ein Treiber 16 vorhanden, der bei Auftreten dieses Signals aktiviert wird, so daß die entsprechenden Warnlampen angesteuert werden.

Die von dem Schaltungsteil 3 versorgten Teile der auf einem Chip integrierten Schaltungsanordnung 1 sind überspannungsfest, so daß eine sichere Abschaltung des Controllers auch bei durchgebranntem Spannungsregler gewährleistet ist.

Ebenso werden die Treiber angesteuert, wenn durch den Watchdog-Schaltungsteil 9 ein Fehler erkannt wird. Wie beschrieben kann dies erfolgen, wenn sich die von dem Mikroprozessor 8 gesendeten Signale ändern oder wenn sich die zweite Referenzspannung ändert, weil auch dies zu einer geänderten Taktrate des Watchdog-Schaltungsteiles 9 führt, die wiederum als Fehler interpretiert wird.

Um im Fehlerfall eine sichere Ansteuerung der Warnlampen zu gewährleisten, sind die Warnlampen vollkommen unabhängig von den Spannungsreferenzen.

Bei der beschriebenen Schaltungsanordnung zeigt sich, daß Spannungsregler und Spannungsüberwachung keine Abhängigkeiten voneinander haben. Dies wird erreicht, in dem auf dem Chip zwei räumlich, mechanisch und elektrisch vollkommen unabhängige Spannungsreferenzen vorgesehen sind. Vorteilhaft kann die zweite Referenzspannung auch noch verwendet werden, um die Referenzströme zur Strombegrenzung der Ventile zu generieren.

Es wird mit einer solchen Schaltungsanordnung also möglich, eine Integration von Spannungsregler 3, Ventiltreiber 15 und Ladungspumpe 14 zur Ansteuerung des Halbleiter-Hauptrelais auf einem Chip zu integrieren bei einer hinreichenden Sicherheit im Fehlerfall.

## Patentansprüche

1. Schaltungsanordnung zur Regelung und zur Spannungsüberwachung einer geregelten Ausgangsspannung in einem Kraftfahrzeug, wobei die geregelte Ausgangsspannung auf das Überschreiten und/ oder Unterschreiten bestimmter Schwellwerte überwacht wird (12), wobei der Schaltungsteil (3) zur Regelung der Ausgangsspannung und der Schaltungsteil (12) zur Überwachung des Über- bzw. Unterschreitens der Schwellwerte auf einem Chip integriert sind, wobei die Regelung der Ausgangsspannung mit einer ersten Referenzspannung (2) erfolgt und wobei das Überwachen des Über- bzw. Unterschreitens der Schwellwerte mit einer zweiten Referenzspannung (4) erfolgt, **dadurch gekennzeichnet, daß** der Chip zwei räumlich, mechanisch und elektrisch unabhängige Spannungsreferenzen für die erste (2) und die zweite (4) Referenzspannung aufweist.

2. Schaltungsanordnung nach Anspruch 1, **dadurch gekennzeichnet, daß** auch die erste Referenzspannung (2) verwendet wird, um die geregelte Ausgangsspannung zu überprüfen (7).

3. Schaltungsanordnung nach Anspruch 1 oder 2, **dadurch gekennzeichnet, daß** mittels der Ausgangsspannung eine weitere elektronische Schaltung (8) versorgt wird, wobei diese Schaltung (8) nicht Bestandteil der Schaltungsanordnung ist und mittels eines auf dem Chip der Schaltungsanordnung integrierten Watchdog-Schaltungsteiles(9) überwacht wird, wobei der Oszillator (11) des Watchdog-Schaltungsteiles (9) mittels der zweiten Referenzspannung (4) versorgt wird.

4. Schaltungsanordnung nach Anspruch 3, **dadurch gekennzeichnet, daß** bei einem durch den Watchdog-Schaltungsteil (9) erkannten Fehler Treiberstufen (14, 15) für externe Verbraucher abgeschaltet werden.

5. Schaltungsanordnung nach Anspruch 4, **dadurch gekennzeichnet, daß** bei einem durch den Watchdog-Schaltungsteil (9) erkannten Fehler eine Treiberstufe (16) zur Einschaltung von Warnlampen aktiviert wird.

6. Schaltungsanordnung nach einem der Ansprüche 3 bis 5, **dadurch gekennzeichnet, daß** die weitere elektronische Schaltung, welche nicht Bestandteil der Schaltungsanordnung ist, ein Mikroprozessor (8) ist, daß die Überprüfung der Ausgangsspannung mittels der ersten Referenzspannung (2) durch einen auf dem Chip der Schaltungsanordnung (1) integrierten Komparator (7) erfolgt, wobei ein Reset des Mikroprozessors (8) erfolgt, wenn von dem Komparator (7) das Über- bzw. Unterschreiten eines bestimmten Schwellwertes erkannt wurde.

7. Schaltungsanordnung nach einem der Ansprüche 1 bis 6, **dadurch gekennzeichnet, daß** die Ausgangsspannung des Schaltungsteiles (3) zur Regelung der Ausgangsspannung einem Eingang eines Komparators (12) zugeführt wird, dessen anderem Eingang die zweite Referenzspannung (4) zugeführt wird, wobei mittels des Komparators (12) überwacht wird, ob ein bestimmter Schwellwert der Ausgangsspannung über- bzw. unterschritten wurde.

8. Schaltungsanordnung nach Anspruch 7, **dadurch gekennzeichnet, daß** bei einem durch den Komparator (12) erkannten Über- bzw. Unterschreiten des bestimmten Schwellwertes Treiberstufen (14, 15) für externe Verbraucher abgeschaltet werden.

9. Schaltungsanordnung nach Anspruch 8, **dadurch gekennzeichnet, daß** bei einem durch den Komparator (12) erkannten Über- bzw. Unterschreiten des bestimmten Schwellwertes eine Treiberstufe (16) zur Einschaltung von Warnlampen aktiviert wird.

## Claims

1. Circuit arrangement to regulate and monitor a regulated output voltage in an automotive vehicle, wherein the regulated output voltage is monitored (in 12) as to whether it exceeds or falls short of defined threshold values, wherein the circuit element (3) for regulating the output voltage and the circuit element (12) for monitoring whether the voltage exceeds or falls short of threshold values are integrated in one chip, wherein the adjustment of the output voltage is effected by way of a first reference voltage (2), and wherein monitoring the voltage as to whether it exceeds or falls short of the threshold values is conducted by way of a second reference voltage (4),
**characterized in that** the chip includes two spatially, mechanically, and electrically independent voltage references for the first (2) and the second (4) reference voltage.

2. Circuit arrangement as claimed in claim 1,
**characterized in that** the first reference voltage (2) is also used to check (in 7) the regulated output voltage.

3. Circuit arrangement as claimed in claim 1 or 2,
**characterized in that** the output voltage is fed to another electronic circuit (8), and this circuit (8) is no component of the circuit arrangement and is monitored by means of a watchdog circuit element (9) integrated in the chip of the circuit arrangement, with the oscillator (11) of the watchdog circuit element (9) being supplied with the second reference voltage (4).

4. Circuit arrangement as claimed in claim 3,
**characterized in that** when an error is detected by the watchdog circuit element (9), driver stages (14, 15) for external consumers will be disconnected.

5. Circuit arrangement as claimed in claim 4,
**characterized in that** when an error is detected by the watchdog circuit element (9), a driver stage (16) for switching on alarm lamps is activated.

6. Circuit arrangement as claimed in anyone of claims 3 to 5,
**characterized in that** the second electronic circuit which is no component of the circuit arrangement is a microprocessor (8), **in that** checking of the output voltage by means of the first reference voltage (2) is carried out by a comparator (7) integrated in the chip of the circuit arrangement (1), and the microprocessor (8) is reset as soon as the comparator (7) detects that the voltage exceeds or falls short of a defined threshold value.

7. Circuit arrangement as claimed in anyone of claims 1 to 6,
**characterized in that** for adjustment of the output voltage, the output voltage of the circuit element (3) is supplied to an input of a comparator (12) whose other input is furnished with the second reference voltage (4), and it is monitored by means of the comparator (12) whether the output voltage exceeds or falls short of a defined threshold value.

8. Circuit arrangement as claimed in claim 7,
**characterized in that** driver stages (14, 15) for external consumers are disconnected when comparator (12) detects that the voltage exceeds or falls short of the defined threshold value.

9. Circuit arrangement as claimed in claim 8,
**characterized in that** a driver stage (16) for switching on alarm lamps is activated when comparator (12) detects that the voltage exceeds or falls short of the defined threshold value.

## Revendications

1. Montage de régulation et de contrôle d'une tension de sortie régulée dans un véhicule automobile, la tension de sortie régulée étant contrôlée (12) quant au dépassement et/ou sous-dépassement de valeurs seuil déterminées, la partie du circuit (3) pour la régulation de la tension de sortie et la partie du circuit (12) pour le contrôle du dépassement ou sous-dépassement des valeurs seuil étant intégrées dans une puce, la régulation de la tension de sortie s'effectuant au moyen d'une première tension de référence (2) et le contrôle du dépassement ou sous-dépassement des valeurs seuil s'effectuant au moyen d'une deuxième tension de référence (4), **caractérisé en ce que** la puce comporte deux références de tension indépendantes dans l'espace, mécaniquement et électriquement, pour la première (2) et la deuxième (4) tensions de référence.

2. Montage selon la revendication 1, **caractérisé en ce qu'**on utilise aussi la première tension de référence (2) pour vérifier (7) la tension de sortie régulée.

3. Montage selon la revendication 1 ou 2, **caractérisé en ce qu'**au moyen de la tension de sortie on alimente un autre circuit électronique (8), ce circuit (8) ne faisant pas partie intégrante du montage et étant contrôlé au moyen d'une partie de circuit "chien de garde" (9) intégrée dans la puce du montage, l'oscillateur (11) de la partie de circuit "chien de garde" (9) étant alimenté au moyen de la deuxième tension de référence (4).

4. Montage selon la revendication 3, **caractérisé en ce qu'**en cas de défaut reconnu par la partie de circuit "chien de garde" (9), des étages d'attaque (14, 15) pour des récepteurs externes sont désactivés.

5. Montage selon la revendication 4, **caractérisé en ce qu'**en cas de défaut reconnu par la partie de circuit "chien de garde" (9), un étage d'attaque (16) est activé pour la mise en service de lampes témoin.

6. Montage selon l'une des revendications 3 à 5, **caractérisé en ce que** l'autre circuit électronique, qui ne fait pas partie intégrante du montage, est un microprocesseur (8), **en ce que** la vérification de la tension de sortie s'effectue au moyen de la première tension de référence (2) par un comparateur (7) intégré dans la puce du montage (1), une réinitialisation du microprocesseur (8) s'effectuant lorsque le comparateur (7) a reconnu le dépassement ou le sous-dépassement d'une valeur seuil déterminée.

7. Montage selon l'une des revendications 1 à 6, **caractérisé en ce que** la tension de sortie de la partie de circuit (3) pour la régulation de la tension de sortie est acheminée vers une entrée d'un comparateur (12) dont l'autre entrée reçoit la deuxième tension de référence (4), le comparateur (12) contrôlant si une valeur seuil déterminée de la tension de sortie a été dépassée ou sous-dépassée.

8. Montage selon la revendication 7, **caractérisé en ce qu'**en cas de dépassement ou sous-dépassement de la valeur seuil déterminée, reconnu par le comparateur (12), des étages d'attaque (14, 15) pour des récepteurs externes sont désactivés.

9. Montage selon la revendication 8, **caractérisé en ce qu'**en cas de dépassement ou sous-dépassement de la valeur seuil déterminée, reconnu par le comparateur (12), un étage d'attaque (16) est activé pour la mise en service de lampes témoin.
